# EUROPÄISCHE PATENTSCHRIFT

(11) **EP 0 242 444 B1**
(45) Veröffentlichungstag und Bekanntmachung des Hinweises auf die Patenterteilung: **10.02.1993**
(21) Anmeldenummer: 86117271.6
(22) Anmeldetag: 11.12.1986
(51) Int. Cl.: H03G 3/30, H04B 1/10, H03G 5/24

(54) **Mobiler Funkempfänger**
Mobile radio receiver
Récepteur radio mobile

(30) Priorität: 17.04.1986 DE 3613048
(43) Veröffentlichungstag der Anmeldung: 28.10.1987
(73) Patentinhaber: ROBERT BOSCH GMBH, 70442 Stuttgart (DE)
(72) Erfinder: Ketterling, Hans-Peter, Dipl.-Ing., D-1000 Berlin 42 (DE)

(56) Entgegenhaltungen:
- CH-A- 261 234
- PATENT ABSTRACTS OF JAPAN, Band 7, Nr. 45 (E-160)[1190], 23. Februar 1983 & JP-A-57 196 634
- PATENT ABSTRACTS OF JAPAN, Band 6, Nr. 164 (E-127)[1042], 27. August 1982 & JP-A-57 84 628
- PATENT ABSTRACTS OF JAPAN, Band 6, Nr. 147 (E-123)[1025], 6. August 1982 & JP-A-57 68 934
- PATENT ABSTRACTS OF JAPAN, Band 9, Nr. 8 (E-289)[1731], 12. Januar 1985 & JP-A-59 158 133
- PATENT ABSTRACTS OF JAPAN, Band 2, Nr. 3, 10. Januar 1977, Seite 9689 E 77 & JP-A-52 117 012

## Beschreibung

### Stand der Technik

Die Erfindung geht von einem mobilen Funkempfänger nach der Gattung des Anspruchs 1 aus.

Die schaltungs- und dimensionierungsbedingte Empfindlichkeit der bekannten mobilen Funkempfänger ist unveränderbar. Dabei tritt das Problem auf, daß eine sehr hohe Interkanalmodulationsfestigkeit des Empfängers bei gleichzeitig sehr hoher Empfindlichkeit kaum zu realisieren ist. In Gebieten hoher Funkverkehrsdichte, das heißt vorzugsweise in Ballungsgebieten, werden in den tieferen Frequenzbändern, zum Beispiel 80 und 160 MHz, aber auch zum Teil in den höheren Frequenzbändern, zum Beispiel 450 MHz, die externen Störungen (man-made noise) so stark, daß die normale Empfindlichkeit der Funkempfänger für diesen Empfangsfall eigentlich zu groß ist. Der Überschuß an nicht benötigter Empfindlichkeit der Funkempfänger kann zwischen 6 und 20 dB liegen. Da gerade in den genannten Gebieten mit sehr starken Interkanalmodulationsstörungen gerechnet werden muß, ist bei normaler Empfindlichkeit des mobilen Empfängers häufig kein befriedigender Funkempfang möglich. In Gebieten mit geringerer Funkverkehrsdichte, das heißt zum Beispiel in ländlichen Gebieten, spielen die Interkanalmodulationsstörungen dagegen meist keine oder nur eine geringere Rolle, und externe Störungen treten auch weniger in Erscheinung. Bei einer größeren Entfernung zwischen mobilem Empfänger und der Feststation reicht die normale Empfindlichkeit des Empfängers dort jedoch kaum aus. Hier wäre also eine höhere Empfindlichkeit bei geringerer Interkanalmodulationsfestigkeit günstiger; denn dadurch würden das Nutzsignal erhöht und der Störabstand verbessert werden.

### Vorteile der Erfindung

Der erfindungsgemäße mobile Funkempfänger mit den kennzeichnenden Merkmalen des Hauptanspruchs hat den Vorteil, eine hohe Empfindlichkeit bei geringer Funkverkehrsdichte und andererseits eine hohe Interkanalmodulationsfestigkeit bei hoher Funkverkehrsdichte zu bieten. Schaltungstechnisch erfordert die Einführung der erfindungsgemäßen Maßnahmen einen verhältnismäßig geringen Aufwand, so daß auch ohne weiteres eine Nachrüstung vorhandener mobiler Funkempfänger möglich ist.

Durch die in den Unteransprüchen aufgeführten Maßnahmen sind vorteilhafte Weiterbildungen und Verbesserungen des im Hauptanspruch angegebenen mobilen Funkempfängers möglich. Besonders vorteilhaft ist ein erfindungsgemäßer mobiler Funkempfänger, bei dem die Steuerung oder Regelung des Hochfrequenzsignalpegels über einen größeren Bereich durch kontinuierliches oder stufenweises Ändern der Verstärkung des Hochfrequenzvorverstärkers erfolgt. Dazu braucht lediglich von der in einem mobilen Funkempfänger ohnehin enthaltenen Rauschsperre ein für die Steuerung oder Regelung des Hochfrequenzvorverstärkers benötigtes Steuersignal abgeleitet zu werden.

### Zeichnung

Ausführungsbeispiele der Erfindung sind in der Zeichnung an Hand mehrerer Figuren dargestellt und in der nachfolgenden Beschreibung näher erläutert. Die Zeichnung zeigt in
- Fig. 1: ein Schaltbild einer Hochfrequenzvorverstärkerstufe mit steuerbarer Gegenkopplung,
- Fig. 2: ein Blockschaltbild einer Rauschsperre zur Erzeugung eines Steuersignals für die Hochfrequenzvorverstärkerstufe,
- Fig. 3: ein Diagramm, aus dem die Wirkung von Rauschsperre und Empfindlichkeitsumschaltung des Empfängers hervorgeht,
- Fig. 4: ein Schaltbild einer Hochfrequenzvorverstärkerstufe mit steuerbarem Doppelgate-Feldeffekttransistor,
- Fig. 5: ein Blockschaltbild mit einem steuer- oder regelbaren Dämpfungsglied, das einem Hochfrequenzvorverstärker vorgeschaltet ist,
- Fig. 6: ein Schaltbild eines steuer- oder regelbaren Dämpfungsgliedes für eine Schaltung nach Fig. 5 und
- Fig. 7: ein Ergänzungsschaltbild zu den Fig. 1 und 2.

### Beschreibung der Erfindung

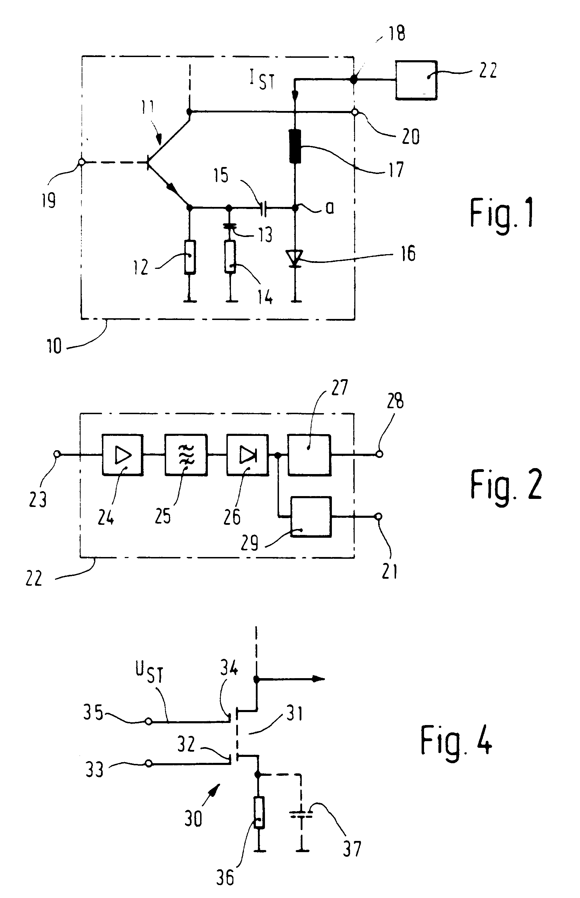

In Fig. 1 bezeichnet 10 eine Hochfrequenzvorverstärkerstufe mit einem bipolaren Transistor 11, dessen Emitter über einen Emitterwiderstand 12 mit Masse verbunden ist. Der Emitterwiderstand wird durch eine Reihenschaltung aus einem Kondensator 13 und einem Widerstand 14 überbrückt. Der Emitter des Transistors 11 ist über einen Kopplungskondensator 15 mit einem Schaltungspunkt a verbunden, der über eine PIN-Diode 16 mit Masse und über eine Hochfrequenzdrossel 17 mit einem Anschluß 18 verbunden ist. Ein Eingang der Hochfrequenzvorverstärkerstufe 10 ist mit 19 und ein Ausgang mit 20 bezeichnet. Der Anschluß 18 ist mit einem zweiten Ausgang 21 einer Rauschsperre 22 verbunden, deren Aufbau in Fig. 2 gezeigt ist. Ein Eingang 23 der Rauschsperre schließt sich zum Beispiel an einen Demodulatorausgang des mobilen Funkempfängers an. Der Eingang 23 steht über eine Reihenschaltung aus einem Verstärker 24, einem Bandpaß 25, einem Gleichrichter 26 und einem ersten Schwellwertschalter 27 mit einem ersten Ausgang 28 der Rauschsperre in Verbindung. Zwischen dem Gleichrichter 26 und dem ersten Schwellwertschalter 27 zweigt ein zweiter Schwellwertschalter 29 ab, dessen Ausgang einen zweiten Ausgang 21 der Rauschsperre bildet.

Die Wirkungsweise der vorstehend beschriebenen Schaltungen nach Fig. 1 und 2 ist folgende.

Eine bei Funkempfängern bekannterweise vorgesehene Rauschsperre umfaßt die Stufen 24, 25, 26 und 27 (Fig. 2). Eine derartige bekannte Rauschsperre liefert an ihrem Ausgang (= erster Ausgang 28 in Fig. 2) beim Unterschreiten eines bestimmten unteren Grenzwertes des Hochfrequenz-Nutzsignalpegels einen ersten Gleichspannungswert, der den Niederfrequenzverstärker des Funkempfängers sperrt. Überschreitet der Hochfrequenz-Nutzsignalpegel einen zweiten Grenzwert, dann liefert die bekannte Rauschsperre an ihrem Ausgang einen zweiten Gleichspannungswert, der den Niederfrequenzverstärker wieder einschaltet. Die Grenzwerte sind in dem ersten Schwellwertschalter 27 fest eingestellt.

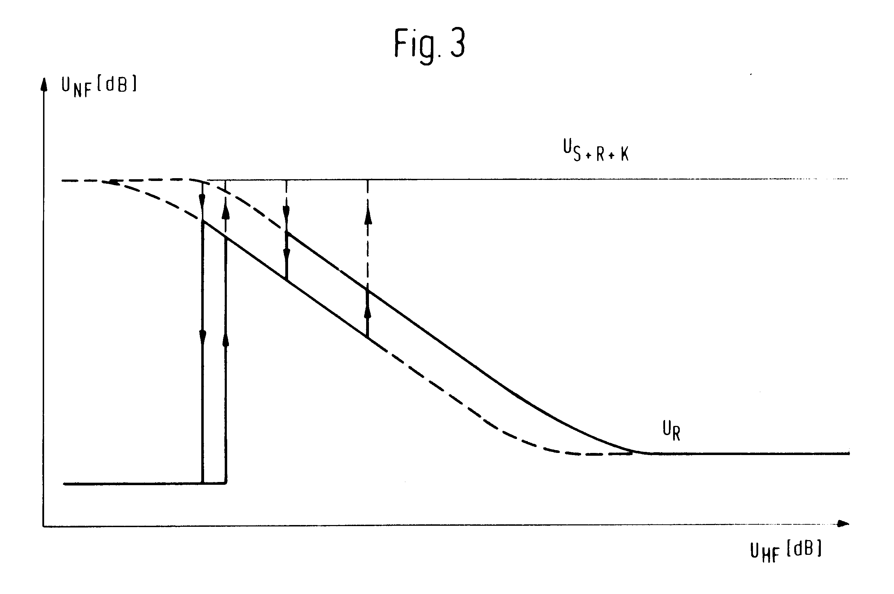

Der in der Rauschsperre 22 nach Fig. 2 vorgesehene zweite Schwellwertschalter 29 hat ebenfalls zwei Grenzwerte, die sich jedoch von den Grenzwerten des ersten Schwellwertschalters 27 etwas unterscheiden, um Überlappungen während des Betriebs zu vermeiden; vgl. Fig. 3. Wird ein erster Hochfrequenz-Grenzwert des zweiten Schwellwertschalters 29 überschritten, so gibt die Rauschsperre 22 an ihrem zweiten Ausgang 21 einen ersten Steuerstrom I_{ST} ab, durch den die PIN-Diode 16 gesperrt wird. Dadurch kommt in der Hochfrequenzvorverstärkerstufe 10 die volle Stromgegenkopplung und damit eine geringere Verstärkung zur Wirkung. Wird ein zweiter Hochfrequenz-Grenzwert unterschritten, so gibt die Rauschsperre an ihrem zweiten Ausgang 21 einen zweiten Steuerstrom I_{ST} ab, durch den die PIN-Diode 16 in den leitenden Zustand gesteuert wird. Damit wird die Stromgegenkopplung unwirksam gemacht und die Verstärkung der Hochfrequenzvorverstärkerstufe 10 erhöht. Ein an dem Eingang 19 der Hochfrequenzvorverstärkerstufe liegendes, mit dem mobilen Funkempfänger empfangenes Hochfrequenzsignal wird somit je nach Empfangslage mehr oder weniger verstärkt. Fig. 3 zeigt den Einfluß von Rauschsperre und Empfindlichkeitumschaltung auf die Empfängerausgangssignale U_{S+R+K} und U_{R}. Hierbei ist U_{S+R+K} die Spannung, welche die Summe von Signal, Rauschen und Klirrprodukten bei vorhandener Modulation zeigt, und U_{R} die Rauschspannung ohne Modulation.

Anstelle der von dem Schwellwertschalter 29 gelieferten zwei Stromwerte können gegegebenenfalls mehrere Stromwerte vorgesehen werden, so daß auch Zwischenwerte der Verstärkung realisierbar sind. Es ist weiterhin möglich, anstelle der stufenweisen Verstärkungseinstellung eine kontinuierliche Verstärkungsregelung vorzunehmen. Die in Fig. 1 gezeigte PIN-Diode 16 kann gegebenenfalls durch eine Schaltdiode mit vorgeschaltetem Widerstand ersetzt werden; dann sind jedoch nur zwei Verstärkungsstufen vorteilhaft realisierbar.

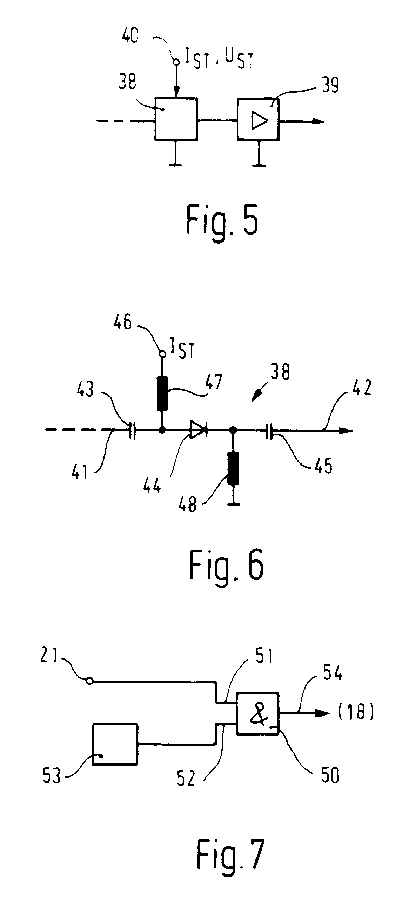

In dem Ausführungsbeispiel nach Fig. 4 bezeichnet 30 eine Hochfrequenzvorverstärkerstufe mit einem Doppelgate-Feldeffekttransistor 31. Ein erstes Gate 32 ist mit einem Eingang 33 der Hochfrequenzvorverstärkerstufe 30 verbunden. Ein zweites Gate 34 steht mit einem Anschluß 35 in Verbindung, an dem eine Steuerspannung U_{ST} liegt. Ein Widerstand 36, der dem Emitterwiderstand 12 in Fig. 1 entspricht, kann gegebenenfalls durch einen Kondensator 37 überbrückt sein. Die Steuerspannung U_{ST} kann auch in diesem Fall von einer Rauschsperre oder einer ähnlich arbeitenden Stufe geliefert werden. Es muß gegebenenfalls empirisch festgestellt werden, ob die Gates 24 und 26, wie in Fig. 4 gezeigt, geschaltet oder vertauscht angeschlossen werden müssen.

In dem Ausführungsbeispiel nach Fig. 5 bezeichnet 38 ein steuer- oder regelbares Dämpfungsglied, das einem Hochfrequenzvorverstärker 39 des mobilen Funkempfängers vorgeschaltet ist. Einem Steuereingang 40 des Dämpfungsgliedes 38 wird je nach Bauart entweder ein Steuerstrom I_{ST} oder eine Steuerspannung U_{ST} zugeführt.

Eine bevorzugte Ausführungsform eines Dämpfungsgliedes 38 ist in Fig. 6 dargestellt. Danach liegt zwischen einem Eingang 41 des Dämpfungsgliedes und einem Ausgang 42 eine Reihenschaltung aus einem ersten Koppelkondensator 43, einer PIN-Diode 44 und einem zweiten Koppelkondensator 45. Zwischen dem ersten Koppelkondensator 43 und der PIN-Diode 44 und einem Anschluß 46 liegt eine erste Drossel 47. Zwischen der Kathode der PIN-Diode 44 und dem zweiten Koppelkondensator 45 besteht eine Verbindung über eine zweite Drossel 48 nach Masse. An die Stelle der PIN-Diode 44 können active oder passive Halbleiter, Kapazitätsdioden, gesteuerte Induktivitäten und gegebenenfalls auch fotoelektrisch gesteuerte Halbleiter treten. Dem Anschluß 46 wird ein Steuerstrom I_{ST} für die PIN-Diode 44 zugeführt. Bei fotoelektrisch steuerbaren Halbleitern entfällt dieser Steueranschluß 46; er wird durch den Lichtstrahl zur Steuerung des fotoelektrischen Halbleiters ersetzt.

Ergänzend kann die Verstärkerungserhöhung nicht nur von einem geringen Hochfrequenz-Nutzsignalpegel abhängig gemacht werden, sondern von dem gleichzeitigen Vorhandensein eines Identifikations- oder Kontrollmerkmals in empfangenen Nutzsignal. Damit findet die Erhöhung nur dann statt, wenn der mobile Funkempfänger ein für ihn bestimmtes Nutzsignal erhält. Zu diesem Zweck wird zwischen dem zweiten Ausgang 21 der Rauschsperre 22 und dem Anschluß 18 der Hochfrequenzvorverstärkerstufe 10 eine UND-Schaltung 50 (Fig. 7) vorgesehen, deren erster Eingang 51 mit dem zweiten Ausgang 21 der Rauschsperre 22 (Fig. 2) und deren zweiter Eingang 52 mit einer Auswerteschaltung 53 für das individuelle Identifikations- oder Kontrollmerkmal des mobilen Funkempfängers verbunden ist. Die Auswerteschaltung, das ist zum Beispiel ein Selektivrufauswerter, liefert dann einen bestimmten Spannungswert an den zweiten Eingang 52 der UND-Schaltung 50, wenn sie den Selektivruf des Funkempfängers erkannt hat. Die Rauschsperre 22 liefert an ihrem zweiten Ausgang 21 den gleichen bestimmten Spannungswert, wenn das Nutzsignal schwach ist. Bei gleichen Spannungswerten (logischen Werten) an den Eingängen 51, 52 gibt die UND-Schaltung 50 an ihrem Ausgang 54 einen Steuerstrom I_{St} ab, der die Verstärkung der Hochfrequenzvorverstärkerstufe 10 erhöht.

Sofern mit dem vorstehend beschriebenen automatisch wirksam werdenden Steuerungen oder Regelungen des Hochfrequenzsignalpegels kein zufriedenstellender Empfang möglich ist, kann wahlweise eine manuelle Steuerung vorgesehen sein, wobei zum Beispiel an den Eingang 18 der Vorverstärkerstufe 10 ein von Hand einstellbarer Gleichstrom angelegt wird.

## Patentansprüche

1. Mobiler Funkempfänger mit einem Hochfrequenzvorverstärker und einer Rauschsperre, dadurch gekennzeichnet, daß die Rauschsperre (22) den Pegel des empfangenen und am Eingang des Funkempfängers zur Verfügung stehenden Hochfrequenz-Nutzsignals derart bewertet, daß in oder vor dem Hochfrequenzvorverstärker (10) bei abnehmendem Hochfrequenz-Nutzsignalpegel der Hochfrequenzsignalpegel erhöht und bei zunehmendem Hochfrequenz-Nutzsignalpegel der Hochfrequenzsignalpegel reduziert wird.

2. Mobiler Funkempfänger nach Anspruch 1, dadurch gekennzeichnet, daß bei einem Hochfrequenz-Nutzsignalpegel, der einen ersten Grenzwert überschreitet, der Hochfrequenzsignalpegel um einen bestimmten Betrag reduziert wird und daß bei einem Hochfrequenz-Nutzsignalpegel, der einen zweiten Grenzwert unterschreitet, der Hochfrequenzsignalpegel um einen bestimmten Betrag erhöht wird.

3. Mobiler Funkempfänger nach Anspruch 1, dadurch gekennzeichnet, daß die Steuerung oder Regelung des Hochfrequenzsignalpegels über einen größeren Bereich durch kontinuierliches oder stufenweises Ändern der Verstärkung des Hochfrequenzvorverstärkers (10) erfolgt.

4. Mobiler Funkempfänger nach Anspruch 1, dadurch gekennzeichnet, daß die Steuerung oder Regelung des Hochfrequenzsignalpegels durch ein dem Hochfrequenzvorverstärker (31) vorgeschaltetes einstellbares Dämpfungsglied (38) erfolgt.

5. Mobiler Funkempfänger nach Anspruch 2, dadurch gekennzeichnet, daß eine dem Hochfrequenz-Nutzsignalpegel entsprechende Steuerspannung (U_{ST}) oder ein entsprechender Steuerstrom (I_{ST}) von einer zu dem Funkempfänger gehörenden Rauschsperre (22) abgeleitet wird.

6. Mobiler Funkempfänger nach einem der Ansprüche 1 bis 5, dadurch gekennzeichnet, daß die Erhöhung des Hochfrequenzsignalpegels bei abnehmendem Hochfrequenz-Nutzsignalpegel nur dann erfolgt, wenn gleichzeitig ein für den mobilen Funkempfänger charakteristisches Identifikations- oder Kontrollsignal zusammen mit dem Hochfrequenzsignal von dem mobilen Funkempfänger empfangen und erkannt worden ist.

7. Mobiler Funkempfänger nach Anspruch 1, 3 oder 4, dadurch gekennzeichnet, daß die Änderung des Hochfrequenzsignalpegels durch manuelle Einstellung erfolgt.

8. Mobiler Funkempfänger nach Anspruch 1 bis 7, dadurch gekennzeichnet, daß der Funkempfänger derart umschaltbar ist, daß der Benutzer wahlweise die automatische oder manuelle Empfindlichkeitsumschaltung einstellen kann.

## Claims

1. Mobile radio receiver having a high frequency pre-amplifier and a noise filter, characterised in that the noise filter (22) evaluates the level of the received high frequency useful signal which is available at the input of the radio receiver in such a way that in the case of a reduction in the high frequency useful signal level, the high frequency signal level is increased in or in advance of the high frequency pre-amplifier (10) and in the case of an increase in the high frequency useful signal level, the high frequency signal level is reduced.

2. Mobile radio receiver as claimed in claim 1, characterised in that in the case of a high frequency useful signal level, which exceeds a first limit value, the high frequency signal level is reduced by a predetermined amount and that in the case of a high frequency signal level, which drops below a second limit value, the high frequency signal level is increased by a predetermined amount.

3. Mobile radio receiver as claimed in claim 1, characterised in that the high frequency signal level is controlled or regulated over a wider range by changing the gain of the high frequency pre-amplifier (10) continuously or stepwise.

4. Mobile radio receiver as claimed in claim 1, characterised in that the high frequency signal level is controlled or regulated by means of an adjustable attenuating element (38) connected in advance of the high frequency pre-amplifier (31).

5. Mobile radio receiver as claimed in claim 2, characterised in that a control voltage (U_{ST}) corresponding to the high frequency useful signal level or a corresponding control current (I_{ST}) is derived from a noise filter (22) which is associated with the radio receiver.

6. Mobile radio receiver as claimed in one of claims 1 to 5, characterised in that in the case of a reduction in the high frequency useful signal level, the high frequency signal level is only increased when the mobile radio receiver simultaneously receives and recognises an identification or control signal characteristic for the mobile radio receiver together with the high frequency signal.

7. Mobile radio receiver as claimed in claim 1, 3 or 4, characterised in that the high frequency signal level is changed by means of manual adjustment.

8. Mobile radio receiver as claimed in claims 1 to 7, characterised in that the radio receiver can be switched over in such a way that the user can set the automatic or manual sensitivity changeover as desired.

## Revendications

1. Récepteur radio mobile comportant un pré-amplificateur à haute fréquence et un filtre de bruit, caractérisé en ce que le filtre de bruit (22) exploite le niveau du signal utile à haute fréquence, reçu, appliqué à l'entrée du récepteur radio, de façon que dans le pré-amplificateur à haute fréquence (10) ou en amont de celui-ci, lorsque le niveau du signal utile à haute fréquence diminue, le niveau du signal à hauts fréquence est augmenté et que lorsque le niveau du signal utile à haute fréquence augmente, le niveau du signal à haute fréquence est réduit.

2. Récepteur radio mobile selon la revendication 1, caractérisé en ce que pour un niveau de signal utile à haute fréquence qui dépasse une première valeur limite, on réduit d'une certaine valeur le niveau du signal de haute fréquence et que pour un niveau de signal utile de haute fréquence qui passe en-dessous d'une seconde limite, on augmente d'une certaine valeur le niveau du signal à haute fréquence.

3. Récepteur radio mobile selon la revendication 1, caractérisé en ce que la commande ou la régulation du niveau du signal à haute fréquence se fait sur une plage importante, par variation continue ou par palier de l'amplification du pré-amplificateur à haute fréquence (10).

4. Récepteur radio mobile selon la revendication 1, caractérisé en ce que la commande ou la régulation du niveau du signal haute fréquence se fait à l'aide d'un élément d'amortissement (38) réglable, prévu en amont du pré-amplificateur à haute fréquence (31).

5. Récepteur radio mobile selon la revendication 2, caractérisé en ce qu'une tension de commande (U_{ST}) ou un courant de commande (I_{ST}) correspondant au niveau du signal utile de haute fréquence sont dérivés dans le filtre de bruit (22) appartenant au récepteur radio

6. Récepteur radio mobile selon l'une des revendications 1 à 5, caractérisé en ce que le niveau du signal à haute fréquence est augmenté lorsque le niveau du signal utile de haute fréquence diminue et si en même temps un signal d'identification ou de commande caractéristique du récepteur radio mobile, ainsi que le signal de haute fréquence ont été reçus et reconnus par le récepteur radio mobile.

7. Récepteur radio mobile selon les revendications 3 et 4, caractérisé en ce que la variation du niveau du signal de haute fréquence se fait par réglage manuel.

8. Récepteur radio mobile selon les revendications 1 à 7, caractérisé en ce que le récepteur radio peut être commuté pour que l'utilisateur puisse régler au choix le circuit de sensibilité automatiquement ou manuellement.
